# EUROPEAN PATENT APPLICATION

(11) **EP 1 589 589 A1**
(43) Date of publication of application: **26.10.2005**
(21) Application number: 03709566.8
(22) Date of filing: 21.02.2003
(51) Int. Cl.: H01L 33/00, H01L 25/10, F21V 7/06, F21S 4/00

(54) **LIGHT EMITTING DIODE LAMP AND MANUFACTURING METHOD THEREOF**

(30) Priority: 31.12.2002 CN 02159987
(71) Applicant: Zhao, Hongtu, Ha'erbin City, Heilongjiang Province 150040 (CN); Zhao, Hongwei, Ha'erbin City, Heilongjiang Province 150040 (CN)
(72) Inventor: Zhao, Hongtu, Ha'erbin City, Heilongjiang Province 150040 (CN); Zhao, Hongwei, Ha'erbin City, Heilongjiang Province 150040 (CN)
(74) Representative: Epping - Hermann - Fischer
(86) International application number: PCT/CN2003/000139
(87) International publication number: WO 2004/059749

(57) **Abstract**

A light-emitting diode lamp consists of a lampwick including one or more light-emitting diode chips and a reflector. Light-emitting surface (206) of the light-emitting diode chips on the lampwick faces to the curved reflection surface (207) of the reflector, and forms an angle of 0-90° with respect to the axis (I) of the reflector (202). Preferably, the reflector consists of one or more paraboloidal reflective mirrors. The axis of the paraboloidal surface parallels to the axis (I) of the reflector (202) and is evenly arranged at equal distance centered at the axis of the reflector. Each light-emitting diode chip or chip-group corresponds to one paraboloidal reflective mirror, and is positioned on a focal point of the paraboloidal reflective mirror. Such lamp has the advantages of narrow illuminating angle and high luminance intensity.

## Description

### Technical field

This invention relates to a light-emitting diode lamp and the manufacturing method thereof.

### Background art

Light-emitting diode has the advantages of long life-span, small volume and light weight, so as a new type of light source, it has been applied more and more widely in the fields like displaying and illuminating. In practical application, it is required in most occasions that the light-emitting diode lamp should have greater brightness and smaller luminous angle (i.e., parallel light in an ideal case). Since the light-emitting diode chip is a area light-emitting source, the luminance intensity thereof is close to the cosine distribution, and the luminous angle is relatively large, it is used only after encapsulating in various manners in practical application.

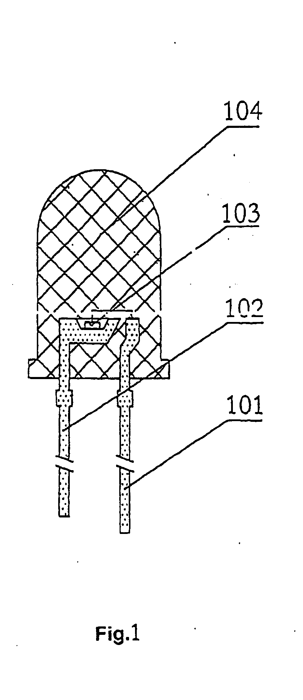

The sectional view of the light-emitting diode lamp that is encapsulated by the prior art encapsulating manner is as shown in Fig. 1, wherein 101 is the anode pin of the light-emitting diode lamp, 102 is the cathode pin of the light-emitting diode lamp, and a concave reflector is provided thereon, 103 is the light-emitting diode chip which is within the concave reflector, 104 is the epoxy resin encapsulation, on the top of which a spherical condenser lens 104 is formed, whose radius of curvature is r, and the distance from the focal point of the lens to the top of the spherical surface is f. In order to make light emit by a relatively small angle, the light-emitting diode chip 103 is on the focal point of the spherical lens. According to the focal length equation f=r*n2/(n2-n1), wherein n2 is the refractive index of the epoxy resin which is about 1.5, and n1 is the refractive index of the air which is about 1, then f is three times of r. Thus light that is smaller than the angle of 30° emitted from the light-emitting diode chip emits at an illuminating angle approximate to 0° through the condenser lens at the position of the focal point of the condenser lens. When illuminating angle of less than 3° is required, the utilization ratio of the light is less than 30%.

Chinese utility model with the patent number of ZL01224722.7 has disclosed an electronic energy-saving lamp of light-emitting diode, wherein coniform reflection shield is used to reflect light emitted from the light-emitting diode on the surface of the lampwick column, but since not all the light-emitting diodes are on the condensing focus of said reflecting shield, the light utilization ratio of the emitted parallel light is low.

Chinese utility model with the patent number of ZL00265474.1 has disclosed a light-emitting diode bulb having a light reflecting cavity, but since not all the light-emitting diodes are on the condensing focus of the reflection film, the light utilization ratio of the emitted parallel light is low.

### Contents of the invention

Therefore, in order to overcome the defects of low utilization ratio and low luminance intensity of light of the prior art light-emitting diode lamp when small illuminating angle is required, the present invention provides a new encapsulated light-emitting diode lamp, which enables the encapsulated light-emitting diode lamp to be used as parallel light source or small angle light source, and to have high luminance intensity which could be widely applied to the fields like car lamps, projector light source, illumination light source, etc.

The principle of the present invention is that light emitted from the focal point of the curved reflection surface is emitted in the direction parallel to the axis of the curved surface after being reflected by said curved reflection surface. The light-emitting diode chip is put on the focal point of the corresponding curved reflective mirror, and the light-emitting surface of the light-emitting diode chip is made to face to the reflective mirror and form an angle of 0-90°with respect to the axis of the reflector, then except that a small part of the light emitted from the chip directly escapes from the opening of the reflective mirror, the rest of the light is parallel to the axis of said curved surface after being reflected by the reflective mirror, thereby the illuminating angle thereof is approximate to 0° and thus the utilization ratio of light is high. Since the light-emitting diode chip is not point light source but area light source, in order to increase the utilization ratio of the reflector, a plurality of light-emitting diodes may be disposed in the shape of regular polygon with the light-emitting surface facing outside. The illuminating angle of the lampwick formed in this manner is 360°, so the luminance intensity is increased without increasing the volume of the lamp. The volume of the lampwick formed by disposing a plurality of light-emitting diodes in the shape of regular polygon is large, and thus cannot be considered as point light source any more, therefore, said curved reflector is divided into a plurality of curved surfaces, so that each light-emitting diode chip corresponds to a focal point of a curved surface. When the reflector is large, the above single chip of light-emitting diode could be consisting of a plurality of chips, while said curved reflector could still be considered as a point light source.

Preferably, said curved surface is a paraboloid.

In a preferred embodiment, said light-emitting surface faces to the reflective mirror and forms the angle of 0-30°with respect to the axis of the reflector.

The present invention further provides a method of manufacturing said light-emitting diode lamp, wherein the reflector having a curved reflection surface is manufactured first; then the lampwick having the light-emitting diode chip(s) or chip group(s) is manufactured, in which the light-emitting surface of the light-emitting diode chip(s) or chip group(s) forms the angle of 0-90°with respect to the axis of said reflector; finally, said lampwick is placed in said reflector and is adjusted to make said light-emitting diode chip(s) or chip group(s) be in the focal point of said curved reflection surface.

### Description of figures

The embodiments of this invention are described in connection with the figures in the following, wherein:
Fig. 1 is the prior art encapsulation of the light-emitting diode;

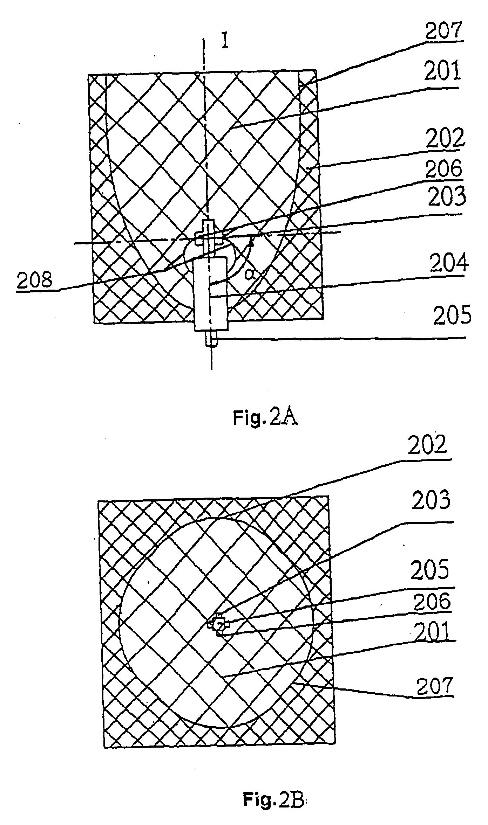

Fig. 2A and Fig. 2B are the profile view and cross section view of the light-emitting diode lamp of the present invention.

### Specific embodiments

The preparation of reflector 202: the reflector is formed of four paraboloidal reflective mirrors 207, the parabola equation is y²=8x and the height thereof is 8mm, the axis of the paraboloid of each reflective mirror is 0.5mm away from the axis I of the reflector and they are distributed symmetrically, the bottom of the reflector has an aperture with a diameter of 2mm centered at the reflector axis I.

The preparation of the lampwick (203, 204, 205): sticking four single sided printed circuit boards with the area of 1x 6mm and the thickness of 0.2mm respectively to the four sides of the copper quadrangular 205 with the area of 1 x1 mm and the height of 10mm by resin glue, wherein 2mm from the top and bottom of the quadrangular 205 are exposed to form a conductive layer (205) of the base (204, 205) of the lampwick; four light-emitting diode chips 203 having the area of 0.3x 0.3mm are respectively solidified by silver slurry at the four sides of the conductive layer (205) of the base of the lampwick at the position of 1mm from the top, so that the cathode of the light-emitting diode chip will electrically contact with said conductive layer 205, and the light-emitting surface 206 of the light-emitting diode chip faces to the curved reflection surface 207 of the reflector 202 and forms an angle of α=30° with said reflector axis I, then the anode of said light-emitting diode chip is bound to another conductive layer 204 of the base of the lampwick by gold wire 208 to form the lampwick.

Put the lampwick into the reflector through the aperture at the bottom, and adjust the position of the lampwick to make each light-emitting diode chip be at the focal point of its corresponding paraboloidal reflector.

In an alternative further step, said light-emitting diode lamp could be encapsulated by resin 201 so as to make it dustproof and dampproof.

The efficiency of the light-emitting diode lamp made according to the above steps could be more than 80% when a divergence angle of smaller than 3° is required.

## Claims

1. A light-emitting diode lamp consisting of a lampwick (203, 204, 205) including light-emitting diode chip(s) (203) and a reflector (202), **characterized in that** the light-emitting surface (206) of the light-emitting diode chips (203) on said lampwick faces to the curved reflection surface (207) of said reflector (202), and is located at the focal point of said curved reflection surface and forms an angle (α) of 0-90° with respect to the axis (I) of the reflector (202).

2. The light-emitting diode lamp according to claim 1, **characterized in that** said curved reflection surface (207) is a paraboloid.

3. The light-emitting diode lamp according to claim 1 or 2, **characterized in that** said light-emitting surface (206) forms an angle (α) of 0-30° with respect to the axis (I) of the reflector.

4. The light-emitting diode lamp according to claim 2 or 3, **characterized in that** said reflector (202) is formed of a plurality of paraboloidal reflective mirrors, the axes of said paraboloidal reflective mirrors are parallel to the axis (I) of the reflector (202) and are distributed evenly at equal distance centered at the axis (I) of the reflector.

5. The light-emitting diode lamp according to claim 4, **characterized in that** the number of said light-emitting diode chip(s) or chip group(s) and said reflective mirror is four.

6. The light-emitting diode lamp according to any one of the preceding claims, **characterized in that** said lampwick (203, 204, 205) is formed of a lampwick base (204, 205) of the shape of regular prism and one or more light-emitting diode chip(s) or chip group(s), and each light-emitting diode chip or chip group is located at one side of said lampwick base, and the lampwick base is formed of a first conductive layer (205) and a second conductive layer (204) which are insulated to each other.

7. The light-emitting diode lamp according to any one of the preceding claims, **characterized in that** it is encapsulated with resin to be dustproof and dampproof.

8. A method of manufacturing the light-emitting diode lamp as stated in claim 1, comprising the steps of:
(1) manufacturing the reflector (202) having a curved reflection surface (207);
(2) manufacturing the lampwick (203, 204, 205) having the light-emitting diode chips (203) or chip groups, and making the light-emitting surface (206) of said light-emitting diode chips (203) or chip groups to form an angle (α) of 0-90° with respect to the axis (I) of said reflector (202);
(3) putting said lampwick into said reflector (202) and adjusting said lampwick to make said light-emitting diode chip(s) or chip group(s) be at the focal point of said curved reflection surface.

9. The method according to claim 8, **characterized by** comprising a further step of encapsulating said lamp with resin.

10. The method according to claim 8 or 9, **characterized in that** said curved reflection surface (207) is a paraboloid.

11. The method according to any one of claims 8-10, **characterized in that** the angle (α) between said light-emitting surface (206) and the axis (I) of said reflector is 0-30°.

12. The method according to any one of claims 10-11, **characterized in that** said reflector (202) is formed of a plurality of paraboloidal reflective mirrors, the axes of said paraboloidal reflective mirrors are parallel to the axis (I) of said reflector (202), and are distributed evenly at equal distance centered at the axis (I) of the reflector.

13. The method according to claim 12, **characterized in that** the number of said light-emitting diode chip(s) or chip group(s) and said reflective mirrors is four.
